# EUROPEAN PATENT SPECIFICATION

(11) **EP 4 202 693 B1**
(45) Date of publication and mention of the grant of the patent: **19.08.2026**
(21) Application number: 22214371.1
(22) Date of filing: 16.12.2022
(51) Int. Cl.: G06F 12/02

(54) **CACHE EVICTIONS MANAGEMENT IN A TWO LEVEL MEMORY CONTROLLER MODE**
CACHERÄUMUNGSVERWALTUNG IN EINEM ZWEISTUFIGEN SPEICHERSTEUERUNGSMODUS
GESTION D'EXPULSION DE MÉMOIRE CACHE DANS UN MODE DE CONTRÔLEUR DE MÉMOIRE À DEUX NIVEAUX

(30) Priority: 22.12.2021 US 202117559870
(43) Date of publication of application: 28.06.2023
(73) Proprietor: INTEL Corporation, Santa Clara, CA 95054 (US)
(72) Inventor: TRIKA, Sanjeev, Portland, 97229 (US); HILDEBRAND, Mark, Portland, 97209 (US); KHAN, Jawad, Portland, 97229 (US)
(74) Representative: 2SPL Patentanwälte PartG mbB

(56) References cited:
- WO-A1-93/20514
- WO-A1-98/58318
- US-A1- 2018 329 651

## Description

### TECHNICAL FIELD

Embodiments generally relate to memory controllers. More particularly, embodiments relate to memory controllers to manage cache evictions in a two level memory controller mode.

### BACKGROUND

Persistent Memory (PM) (e.g., INTEL OPTANE) is now broadly supported on datacenter platforms and is rapidly increasing in adoption. In *Memory Mode* (e.g., also known as two-level memory (*2LM*) mode), the PM is used to extend the system-visible DRAM. In this such a two-level memory mode, the system DRAM is used to cache (or tier) a bigger capacity PM, thereby making a much bigger capacity PM visible to the operating system (OS) at a fraction of the cost that one would have to pay if backed by all DRAM. For cost, complexity, and performance reasons, the caching that is done in current products by the platform memory controller in system DRAM is write-back, 1-way set-associative, insert-all caching.

WO 98/58318 A1 discloses an efficient use of a cache memory in a computer system. The system comprises a processor, a local bus comprising local address and local data buses coupled to the processor, a cache memory coupled to the local bus, a bus interface coupled to the local bus for coupling the processor to a main memory via an external bus and a transparent write cache policy (TWCP) controller functionally coupled between the processor and bus interface.

WO 93/ 20514 A1 discloses a self-controlled microcomputer write back cache memory apparatus for the controlled storage of digital data in a high speed microcomputer including memory means for storing digital data in the form of cache lines, comparator means for determining whether the data requested by the CPU is present in the memory means, cache controller means for generating control signals otherwise produced by the CPU toward producing a memory write cycle and buffers to facilitate the controlled storage of the digital data.

US 2018/329651 A1 discloses memory module including a memory controller including: a host layer; a media layer coupled to a non-volatile memory; and a logic core coupled to the host layer, the media layer, and a volatile memory, the logic core storing a first write group table including a plurality of rows, and the logic core being configured to: receive a persistent write command including a cache line address and a write group identifier; receive data associated with the persistent write command; write the data to the volatile memory at the cache line address; store the cache line address in a selected buffer of a plurality of buffers in a second write group table, the selected buffer corresponding to the write group identifier; and update a row of the first write group table to identify locations of the selected buffer containing valid entries, the row corresponding to the write group identifier.

### SUMMARY

The invention is set out in the appended set of claims. The dependent claims set out particular embodiments.

### BRIEF DESCRIPTION OF THE DRAWINGS

The various advantages of the embodiments will become apparent to one skilled in the art by reading the following specification and appended claims, and by referencing the following drawings, in which:
FIG. 1 is a block diagram of an example computing system according to an embodiment;
FIG. 2 is an illustration of another example of a computing system according to an embodiment;
FIG. 3 is a block diagram of an example of a tiered memory according to an embodiment;
FIG. 4 is a chart of an example of a method of managing cache evictions according to an embodiment;
FIG. 5 is another chart of an example of a method of managing cache evictions according to an embodiment; and
FIG. 6 is an illustration of an example of a semiconductor package apparatus according to an embodiment.

### DESCRIPTION OF EMBODIMENTS

As discussed above, in a two-level memory mode, the system DRAM is used to cache (or tier) a bigger capacity PM, thereby making a much bigger capacity PM visible to the operating system (OS) at a fraction of the cost that one would have to pay if backed by all DRAM. However, there are many scenarios when the data that is written to DRAM is never used (e.g., such data is typically decided by the applications or operating-system as not useful and is overwritten without reads).

For example, application memory returned to an active application's allocator (e.g., via a call to "free") may, depending on the allocator implementation, be modified in an undefined manner without impacting the correctness of the application. This is illustrated in machine learning training, where significant deallocations typically occur in every iteration of training. Depending on the workload, this can omit gigabytes of unnecessary writebacks per iteration. If such unnecessary operations were eliminated, the techniques described herein can improve performance by 20-25% and endurance by 1.5 times.

As another example, upon a shutdown, system DRAM cache can be discarded rather than flushing it to the backing media, since the memory content is discarded upon reboot. Further, application-close is another event after which previously allocated and used DRAM is no longer needed. In such scenarios, the flush of the dirty-but-invalid data in the DRAM cache to the persistent media is wasteful in both performance and media-endurance.

As will be described in greater detail below, some implementations described herein provide techniques that eliminate data-flushes of unneeded dirty-but-invalid data from DRAM to persistent memory. In a different technology area (e.g., in the disk-caching space) SSD-Trim commands may mark disk-cached data as invalid; however, such an SSD-Trim command does not work for two-level memory mode implementations, and the triggering events for such an SSD-Trim command are also different for memory operations as compared to storage operations.

As will be described in greater detail below, some implementations described herein provide for a memory controller to manage cache evictions and/or insertions in a two level memory controller mode that uses a dynamic random access memory as a transparent cache for a persistent memory. For example, a memory controller includes logic to map cached data in the dynamic random access memory to an original address of copied data in the persistent memory. The cached data in the dynamic random access memory is tracked as to whether it is valid or invalid data with respect to the copied data in the persistent memory. Upon eviction of the cached data from the dynamic random access memory, a writeback of the cached data that has been evicted to the persistent memory is bypassed when the cached data is tracked as invalid data.

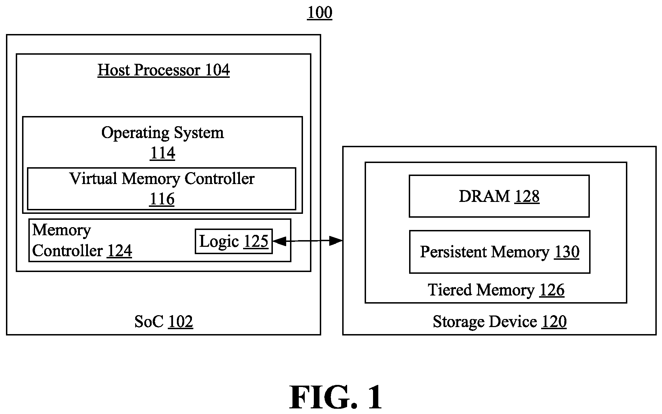

FIG. 1 is a block diagram of a computing system 100. In the illustrated example, a storage device 120 (e.g., a two-level memory (2LM), or the like) is in communication with a system on chip (SoC) 102.

As illustrated system on chip (SoC) 102 includes a host processor 104 (e.g., central processing unit/CPU). The host processor 104 typically includes a memory controller 124 (e.g., an integrated memory controller (IMC)) that communicates with storage device 120. The illustrated computing system 100 may include other components, such as operating system 114 (OS) having a virtual memory controller 116 for example.

In some implementations, the memory controller 124 is adapted to include a "memory-invalidate" command for a memory range. The memory controller 124 for two-level memory mode implementations is extended to process these commands by marking the corresponding cachelines, if present in DRAM, as invalid or valid and/or as dirty or clean. Similarly, such a "memory-invalidate" command is used by the OS 114, and also made available to applications. For example, the virtual memory manager 116 of the OS 114 uses this command when a memory region is de-allocated (e.g., on system shutdowns, on free/delete calls, and/or the like). Likewise, active applications use this command based on application specific knowledge of memory use. As an extension, compilers/interpreters may call the memory-invalidate command when they detect that a memory-range is no longer in use by the application, for example.

The storage device 120 is implementable in several formats. For example, storage device 120 is implementable as two-level memory (2LM), or the like. The storage device 120 includes a tiered memory 126 that includes a dynamic random access memory 128 and a persistent memory 130. In 2LM implementations, any of a first level memory of the 2LM and a second level memory of the 2LM may include persistent memory and/or volatile memory. For example, the 2LM may correspond to system memory or main memory having a near memory and a far memory. The first level memory of the 2LM may correspond to the near memory and include smaller, faster DRAM. The second level memory of the 2LM may correspond to the far memory and include larger storage capacity persistent memory (e.g., a byte-addressable 3D crosspoint memory).

Additionally, or alternatively, in some implementations, block 120 might not encompass an actual storage device. For example, in a systems running in the 2LM mode, byte-addressable 3D crosspoint memory (and/or the like) might not actually used for its persistence, merely for its capacity and is thus treated as volatile memory. Similarly, some implementations described herein can be extended to other volatile tiered memory systems such as using Multi-Channel DRAM (MCDRAM) as a super-fast cache for DRAM, and/or the like. For example, some implementations described herein can utilize DRAM as a cache for slower volatile memory or utilize MCDRAM/High Bandwidth Memory (HBM) as a cache for DRAM.

To that end, this idea can be extended to other volatile tiered memory systems such as using Multi-Channel DRAM (MCDRAM) as a super-fast cache for DRAM.

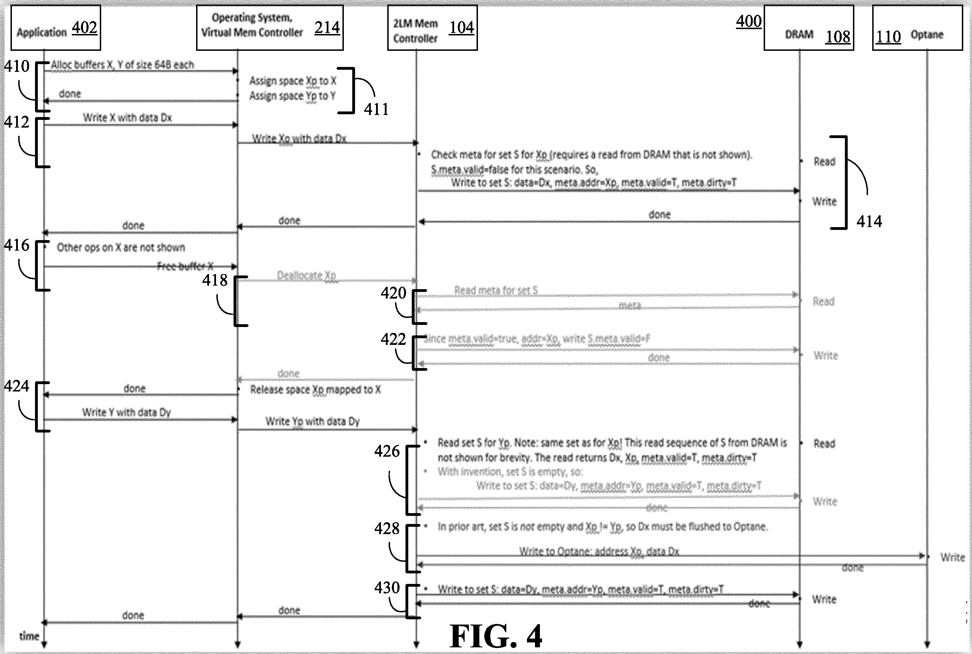

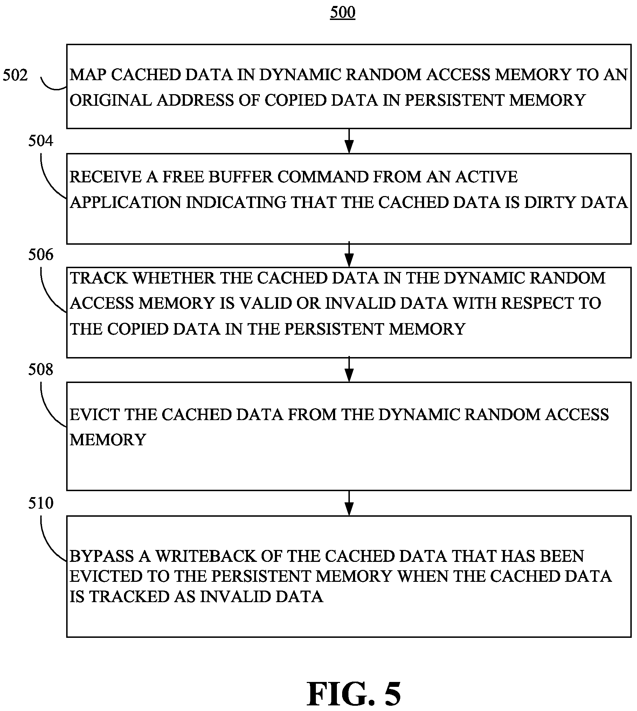

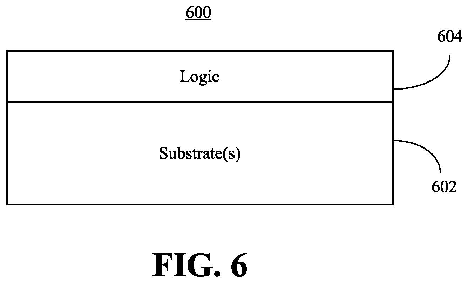

Commands (for example, read, write ("program"), and/or erase commands for the tiered memory 126) received from the host are queued and processed by the memory controller 124. The logic 125 of memory controller is implementable via transistor array, other integrated circuit/IC components, the like, and combinations thereof. In some examples, the logic 125 of the memory controller 124 is integrated onto a semiconductor die (e.g., integrated into host processor 104), as will be discussed in greater detail below with respect to FIG. 6. In some examples, the logic 125 of memory controller 124, which may include one or more of configurable or fixed-functionality hardware, is configured to perform one or more aspects of the method 400 (FIG. 4) and/or the method 500 (FIG. 5), which are discussed in more detail below.

As will be described in greater detail below, the memory controller 124 manages cache evictions. For example, the memory controller 124 of a memory device (e.g., storage device 120) is capable of managing evictions and/or insertions in a two level memory controller mode that uses the dynamic random access memory 128 as a transparent cache for the persistent memory 130. For example, the memory controller 124 includes logic 125 to map cached data in the dynamic random access memory 128 to an original address of copied data in the persistent memory 130. The cached data in the dynamic random access memory 128 is tracked as to whether it is invalid or valid and/or as dirty or clean with respect to the copied data in the persistent memory 130. Upon eviction of the cached data from the dynamic random access memory 128, a writeback of the cached data that has been evicted to the persistent memory 130 is bypassed when the cached data is tracked as dirty-but-invalid data by the memory controller 124.

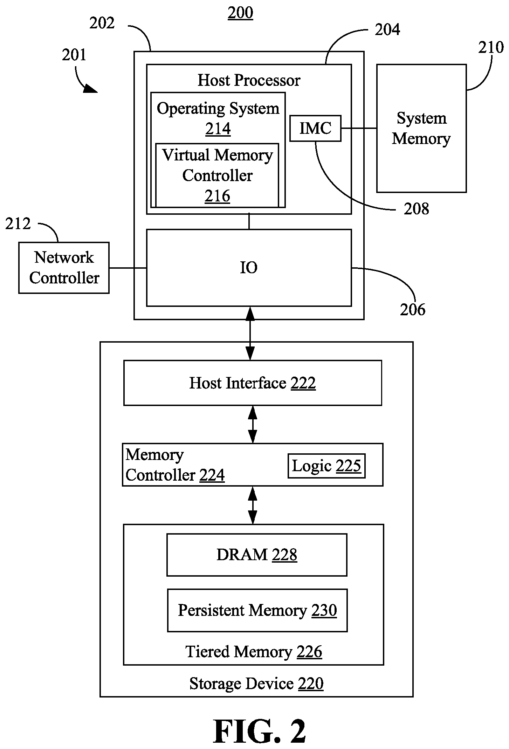

Turning now to FIG. 2, a computing system 200 is shown. In the illustrated example, storage device 220 (e.g., a solid state drive (SSD)) is in communication with a host 201.

The illustrated computing system 200 also includes a system on chip (SoC) 202 having a host processor 204 (e.g., central processing unit/CPU) and an input/output (IO) module 206. The host processor 204 typically includes an integrated memory controller (IMC) 208 that communicates with system memory 210 (e.g., dynamic random access memory/DRAM). The illustrated IO module 206 is coupled to the storage device 220 (e.g., a solid state drive (SSD)) as well as other system components such as a network controller 212.

The illustrated computing system 200 may include other components, such as operating system (OS) 214 having a virtual memory controller 216, for example. In some implementations, the memory controller 224 is adapted to include a "memory-invalidate" command for a memory range. The memory controller 224 for two-level memory mode implementations is extended to process these commands by marking the corresponding cachelines, if present in DRAM, as invalid or valid and/or as dirty or clean. Similarly, such a "memory-invalidate" command is used by the OS 214, and also made available to applications. For example, the virtual memory manager 216 of the OS 214 uses this command when a memory region is de-allocated (e.g., on system shutdowns, on free/delete calls, and/or the like). Likewise, active applications use this command based on application specific knowledge of memory use. As an extension, compilers/interpreters may call the memory-invalidate command when they detect that a memory-range is no longer in use by the application, for example.

The storage device 220 is implementable in several formats. For example, storage device 220 is implementable as a solid state drive (SSD). The storage device 220 includes a host interface 222, a memory controller 224 that includes logic 225, and a tiered memory 226 that includes a dynamic random access memory 228 and a persistent memory 230.

In some embodiments, the host interface 222 communicatively couples memory controller 224 to the host 202. For example, host interface 222 communicatively couples memory controller 224 to the host using the NVMe (NVM express) protocol over PCIe (Peripheral Component Interconnect Express) or Fabric. Additionally, or alternatively, Compute Express Link (CXL) interconnect may be utilized to provide a concrete mechanism for cache coherent devices connected via PCIe. Commands (for example, read, write ("program"), and/or erase commands for the tiered memory 226) received from the host are queued and processed by the memory controller 224.

The logic 225 of memory controller is implementable via transistor array, other integrated circuit/IC components, the like, and combinations thereof. In some examples, the logic 225 of the memory controller 224 is integrated onto a semiconductor die, as will be discussed in greater detail below with respect to FIG. 6. In some examples, the logic 225 of memory controller 224, which may include one or more of configurable or fixed-functionality hardware, is configured to perform one or more aspects of the method 400 (FIG. 4) and/or the method 500 (FIG. 5), which are discussed in more detail below.

As will be described in greater detail below, the memory controller 224 manages cache evictions. For example, the memory controller 224 of a memory device (e.g., storage device 220) is capable of managing evictions and/or insertions in a two level memory controller mode that uses the dynamic random access memory 228 as a transparent cache for the persistent memory 230. For example, the memory controller 224 includes logic 225 to map cached data in the dynamic random access memory 228 to an original address of copied data in the persistent memory 230. The cached data in the dynamic random access memory 228 is tracked as to whether it is clean, dirty-but-invalid data, or dirty-and-valid data with respect to the copied data in the persistent memory 230. Upon eviction of the cached data from the dynamic random access memory 228, a writeback of the cached data that has been evicted to the persistent memory 230 is bypassed when the cached data is tracked as dirty-but-invalid data by the memory controller 224.

In some implementations, the persistent memory 230 and/or persistent memory 120 includes single-level cell (SLC) memory, MLC (two level), TLC (three level), quad-level cell (QLC) memory, PLC (five level in development), three-dimensional (3D) crosspoint memory, INTEL OPTANE three-dimensional (3D) crosspoint memory, the like, and/or combinations thereof. For example, the persistent memory 230 and/or persistent memory 130 is implementable as a transistor-less stackable cross point architecture-type persistent memory or the like. Such transistor-less stackable cross point architecture-type persistent memory (e.g., INTEL OPTANE persistent memory) has memory cells (e.g., sitting at the intersection of word lines and bit lines) that are distributed across a plurality of storage dies and are individually addressable, and in which bit storage is based on a change in bulk resistance and the like.

The storage device 220 and/or storage device 120 may be part of a memory device that includes non-volatile memory and/or volatile memory. Non-volatile memory is a storage medium that does not require power to maintain the state of data stored by the medium. In one embodiment, the memory structure is a block addressable storage device, such as those based on NAND or NOR technologies. A storage device may also include future generation nonvolatile devices, such as a three-dimensional (3D) crosspoint memory device, or other byte addressable write-in-place nonvolatile memory devices. In one embodiment, the storage device may be or may include memory devices that use silicon-oxide-nitride-oxide-silicon (SONOS) memory, electrically erasable programmable read-only memory (EEPROM), chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a DW (Domain Wall) and SOT (Spin Orbit Transfer) based device, a thiristor based memory device, or a combination of any of the above, or other memory. The term "storage device" may refer to the die itself and/or to a packaged memory product. In some embodiments, 3D crosspoint memory may comprise a transistor-less stackable cross point architecture in which memory cells sit at the intersection of word lines and bit lines and are individually addressable and in which bit storage is based on a change in bulk resistance. In particular embodiments, a memory module with non-volatile memory may comply with one or more standards promulgated by the Joint Electron Device Engineering Council (JEDEC), such as JESD235, JESD218, JESD219, JESD220-1, JESD223B, JESD223-1, or other suitable standard (the JEDEC standards cited herein are available at jedec.org).

Volatile memory is a storage medium that requires power to maintain the state of data stored by the medium. Examples of volatile memory may include various types of random access memory (RAM), such as dynamic random access memory (DRAM) or static random access memory (SRAM). One particular type of DRAM that may be used in a memory module is synchronous dynamic random access memory (SDRAM). In particular embodiments, DRAM of the memory modules complies with a standard promulgated by JEDEC, such as JESD79F for Double Data Rate (DDR) SDRAM, JESD79-2F for DDR2 SDRAM, JESD79-3F for DDR3 SDRAM, or JESD79-4A for DDR4 SDRAM (these standards are available at jedec.org). Such standards (and similar standards) may be referred to as DDR-based standards and communication interfaces of the storage devices that implement such standards may be referred to as DDR-based interfaces.

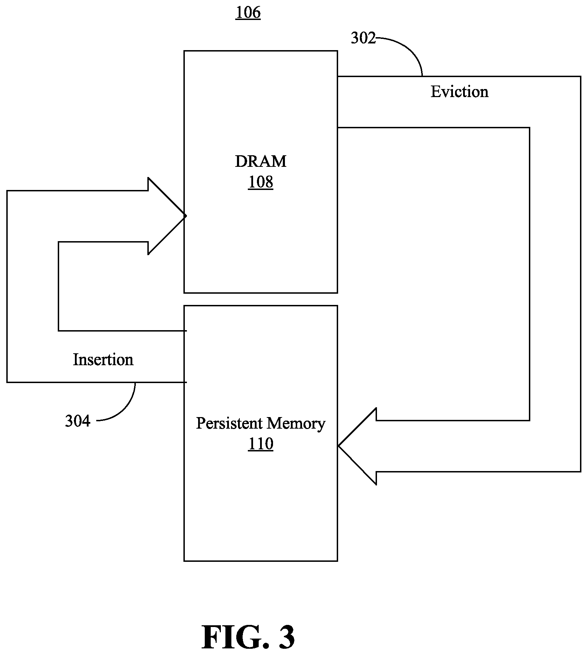

FIG. 3 shows an illustrative example of the tiered memory 126 (e.g., or 226 from FIG. 2). In the illustrated example, the tiered memory 126 (e.g., or 226 from FIG. 2) includes the dynamic random access memory 128 (e.g., or 228 from FIG. 2)and the persistent memory 130 (e.g., or 230 from FIG. 2). As illustrated, memory blocks in the dynamic random access memory 128 (e.g., or 228 from FIG. 2) are capable of being converted into the persistent memory 130 (e.g., or 230 from FIG. 2) memory blocks via an eviction 302 policy. Additionally, or alternatively, memory blocks in the persistent memory 130 (e.g., or 230 from FIG. 2) are capable of being converted into the dynamic random access memory 128 (e.g., or 228 from FIG. 2) memory blocks via an insertion 304 policy.

In operation, memory blocks in the dynamic random access memory 128 (e.g., or 228 from FIG. 2) are capable of being subject to eviction 302 to the persistent memory 130. Additionally, or alternatively, memory blocks in the persistent memory 130 (e.g., or 230 from FIG. 2) are capable of being converted into the dynamic random access memory 128 (e.g., or 228 from FIG. 2) memory blocks via insertion 304.

Thus, memory blocks in the dynamic random access memory 128 (e.g., or 228 from FIG. 2) formerly containing evicted data may be subsequently used as the persistent memory 130 (e.g., or 230 from FIG. 2) memory blocks, which have a greater storage capacity. Management of the evictions 302 may enable the tiered memory 126 (e.g., or 226 from FIG. 2) to operate at a greater bandwidth.. Additionally, or alternatively, a user of the tiered memory 126 (e.g., or 226 from FIG. 2) may perceive enhanced performance and faster writes to the dynamic random access memory 128 (e.g., or 228 from FIG. 2) as compared to the persistent memory 130 (e.g., or 230 from FIG. 2).

FIG. 4 is a chart of an example of a method 400 of managing cache evictions according to an embodiment. The method 400 may generally be implemented in a memory controller, such as, for example, the memory controller 124 (e.g., see FIG. 1 and memory controller 224 from FIG. 2), already discussed.

More particularly, the method 400 may be implemented in one or more modules as a set of logic instructions stored in a machine- or computer-readable storage medium such as random access memory (RAM), read only memory (ROM), programmable ROM (PROM), firmware, flash memory, etc., in hardware, or any combination thereof. For example, hardware implementations may include configurable logic, fixed-functionality logic, or any combination thereof. Examples of configurable logic include suitably configured programmable logic arrays (PLAs), field programmable gate arrays (FPGAs), complex programmable logic devices (CPLDs), and general purpose microprocessors. Examples of fixed-functionality logic include suitably configured application specific integrated circuits (ASICs), combinational logic circuits, and sequential logic circuits. The configurable or fixed-functionality logic can be implemented with complementary metal oxide semiconductor (CMOS) logic circuits, transistor-transistor logic (TTL) logic circuits, or other circuits.

As will be described below, a persistent memory write is advantageously eliminated (e.g., a memory write that typically occurs in existing methods) in method 400 in exchange for adding three much faster additional DRAM operations. This improves the net latency of the operation and the system endurance as well.

Method 400 starts with the application 402 requesting virtual memory buffers X and Y, which are assigned physically addresses/ranges Xp and Yp respectively by the operating system 214 and the virtual memory controller 216.

For example, at Illustrated processing block 402, an active application 402 allocates a memory buffer at virtual address X and another at virtual address Y. Active application 402 writes data to X, but later frees it after use.

At Illustrated processing block 424, the active application 402 then writes data to Y.

At Illustrated processing block 411, a cache controller in the memory controller 142 maps physical addresses of X (e.g., denoted Xp) and Y (e.g., denoted Yp) to the same cache-set for this example.

At Illustrated processing block 412, a write to range X with data Dx occurs. For example, upon a write to range X with data Dx, the method 400 wishes to insert Dx into DRAM into a cache-set S corresponding to address Xp.

At Illustrated processing block 416, a DRAM read is performed to determine whether the set S available. Since this is the first access to S in this example, the location is determined to be available, and a corresponding write request to is issued DRAM, and the requests are completed all the way back to the application 402.

At Illustrated processing block 416, the application 202 frees the buffer X.

At Illustrated processing block 418, when the application 202 frees the buffer X, the OS 214 issues a new deallocate request for Xp to the memory controller 124 (e.g., in the two level memory mode).

At Illustrated processing block 420, the memory controller 124 (e.g., in the two level memory mode) checks that Xp is in the cache (DRAM).

At Illustrated processing block 422, the memory controller 124 (e.g., in the two level memory mode) updates its metadata to mark the cache line as empty (e.g., invalid). For example, this marking is utilized by method 400 to eliminate a subsequent flush (e.g., as illustrated by bypassing processing block 428 operation) of the cache line to the persistent memory 130 upon a conflict miss with Y (as will be described below).

At Illustrated processing block 426, upon a write to range Y with data Dy, the method 400 wishes to insert Dy into DRAM into the cache set S corresponding to address Yp. In this exemplary scenario, this is the same cache set S as for Xp. Accordingly, at illustrated processing block 426, the memory controller 124 (e.g., in the two level memory mode) discovers that the set S is already empty (e.g., as meta.valid = False), and therefore no eviction to persistent memory 130 is required.

At Illustrated processing block 430, Dy is written to persistent memory 130 to complete the operation.

In operation, as compared to existing methods, the method 400 adds a DRAM read and two DRAM writes, while one persistent memory write is eliminated. Since persistent memory write operations are about 100 times slower than DRAM read and write operations, method 400 advantageously provides a media-access time speedup of more than thirty times. The persistent memory endurance is also improved by eliminating the persistent memory write-request.

Conversely, in existing solutions, the operating system and the virtual memory controller simply release the space Xp, and no updates are required to system DRAM 128 (or DRAM 228 in FIG. 2) or persistent memory 130 (or persistent memory 230 in FIG. 2 for 2LM management. Further, in such existing solutions, the existing system discovers that the set is full in DRAM (e.g., by doing a DRAM read for Dx and associated metadata) and must evict X to the persistent memory 130 to be able to write Y into the DRAM cache (e.g., as Y is newer). Note that keeping Dx in the cache, while possible, would be sub-optimal since X has been freed. Accordingly, the existing system writes Dx to persistent memory 130 at address Xp as part of the eviction, which is very time consuming.

The techniques described herein are generally described with respect to an exemplary implementation where the two-level memory mode memory controller uses the DRAM to cache the data that is in the persistent memory. It will be understood, however, that the techniques described herein are equally applicable to configurations where tiering (e.g., data is exclusively in one of the two medias) is used instead.

Similarly, the techniques described herein are generally described with respect to an exemplary implementation in the context of an application freeing a memory range. It will be understood, however, that the techniques described herein are equally applicable to situations where the OS may call the deallocate command during garbage collection when the OS recognizes that a memory region is no longer needed. In such a situation, the application may trigger the command as well to indicate that a buffer space is still needed (e.g., do not free the allocation) but the data there is no longer relevant to the application. Similarly, compilers and interpreters (e.g., for programming languages that have automatic memory management) can insert deallocate commands when the compilers and interpreters determine that a memory buffer is going out of scope/use and no longer needed.

Additionally, or alternatively, it will be appreciated that while the techniques described herein were discussed in the context of a 1-way set-associative insert-all cache, techniques described herein also generalize to other caching policies and mechanisms.

Additional and/or alternative operations for method 400 are described in greater detail below in the description of FIGS. 5 and FIG. 6.

FIG. 5 is another chart of an example of a method 500 of managing cache evictions according to an embodiment. The method 500 may generally be implemented in a memory controller, such as, for example, the memory controller 124 (e.g., see FIG. 1 and memory controller 224 from FIG. 2), already discussed.

More particularly, the method 500 may be implemented in one or more modules as a set of logic instructions stored in a machine- or computer-readable storage medium such as random access memory (RAM), read only memory (ROM), programmable ROM (PROM), firmware, flash memory, etc., in hardware, or any combination thereof. For example, hardware implementations may include configurable logic, fixed-functionality logic, or any combination thereof. Examples of configurable logic include suitably configured programmable logic arrays (PLAs), field programmable gate arrays (FPGAs), complex programmable logic devices (CPLDs), and general purpose microprocessors. Examples of fixed-functionality logic include suitably configured application specific integrated circuits (ASICs), combinational logic circuits, and sequential logic circuits. The configurable or fixed-functionality logic can be implemented with complementary metal oxide semiconductor (CMOS) logic circuits, transistor-transistor logic (TTL) logic circuits, or other circuits.

Illustrated processing block 502 provides for operations to map cached data. For example, cached data is mapped in a dynamic random access memory to an original address of copied data in a persistent memory.

In some implementations, the memory controller includes a two level memory controller mode that uses the dynamic random access memory as a transparent cache for the persistent memory. In some examples, the two level memory controller mode is implemented as hardware to manage dynamic random access memory cache for the persistent memory.

In some examples, the persistent memory extends the dynamic random access memory where the dynamic random access memory is system visible. In some implementations, the persistent memory has a write bandwidth that is lower than and a storage capacity that is larger than the dynamic random access memory.

Illustrated processing block 504 provides for operations to receive a free buffer command. For example, a free buffer command is received from an active application indicating that the cached data is invalid data (e.g., also including free data). In some examples, operations to track the cached data as invalid data is based on the received free buffer command.

Illustrated processing block 506 provides for operations to track whether the cached data in the dynamic random access memory is valid data or invalid data (e.g., also including free data). For example, the cached data in the dynamic random access memory is tracked as to whether it is valid or invalid with respect to the copied data in the persistent memory.

In some examples, tracking the cached data as invalid is based on one or more of the following events: a deallocation of data during an iteration of machine learning training, upon a system shutdown, a closing of the active application, the like, and/or combinations thereof.

In some examples, dirty data and clean data are also tracked. For example, such dirty data includes one or more of the following: duplicate data, outdated data, insecure data, incorrect data, incomplete data, inconsistent data, the like, and/or combinations thereof.

In some implementations, the operation to track the cached data is includes an operation to mark cached data as valid or invalid and as dirty or clean. As a result, data can be in three states: clean, dirty-and-valid, and dirty-but-invalid. In particular, the operation to bypass the writeback of the cached data is performed in response to the cached data being marked as dirty but invalid data.

Illustrated processing block 508 provides for operations to evict the cached data. For example, the cached data is evicted from the dynamic random access memory.

Illustrated processing block 510 provides for operations to bypass a writeback of the cached data. For example, a writeback of the cached data that has been evicted to the persistent memory is bypassed when the cached data is tracked as invalid data.

In another example, a writeback of the cached data that has been evicted to the persistent memory is bypassed when the cached data is tracked as dirty-but-invalid data as well as clean data and performed when the cached data is tracked as dirty-and-valid data.

In some implementations, one or more of the operations to: track valid or invalid data, mark the cached data as valid or invalid and as dirty or valid, evict the cached data, and bypass the writeback, are performed in the two level memory controller mode by the memory controller.

Additional and/or alternative operations for method 500 are described in greater detail below in the description of FIG. 6.

FIG. 6 shows a semiconductor apparatus 600 (e.g., chip and/or package). The illustrated apparatus 600 includes one or more substrates 602 (e.g., silicon, sapphire, gallium arsenide) and logic 604 (e.g., transistor array and other integrated circuit/IC components) coupled to the substrate(s) 602. In an embodiment, the logic 604 implements one or more aspects of the method 400 (FIG. 4) and/or the method 500 (FIG. 5), already discussed.

In some implementations, when operated as a controller, the logic 604 is to manage cache evictions and/or insertions in a two level memory controller mode that uses a dynamic random access memory as a transparent cache for a persistent memory. For example, logic 604 is to map cached data in the dynamic random access memory to an original address of copied data in the persistent memory. The cached data in the dynamic random access memory is tracked as to whether it is clean, dirty-but-invalid data, or dirty-and-valid data with respect to the copied data in the persistent memory. Upon eviction of the cached data from the dynamic random access memory, a writeback of the cached data that has been evicted to the persistent memory is bypassed when the cached data is tracked as dirty invalid data by the logic 604.

In one example, the logic 604 includes transistor channel regions that are positioned (e.g., embedded) within the substrate(s) 602. Thus, the interface between the logic 604 and the substrate 602 may not be an abrupt junction. The logic 604 may also be considered to include an epitaxial layer that is grown on an initial wafer of the substrate 602.

Technology described herein may therefore provide a performance-enhanced computing platform to the extent that it may advantageously improve resource utilization. For example, as compared to existing methods, the technology described herein advantageously adds a DRAM read and two DRAM writes, while one persistent memory write is eliminated. Since persistent memory write operations are about 100 times slower than DRAM read and write operations, technology described herein advantageously provides a media-access time speedup of more than thirty times. The persistent memory endurance is also improved by eliminating the persistent memory write-request.

Embodiments are applicable for use with all types of semiconductor integrated circuit ("IC") chips. Examples of these IC chips include but are not limited to processors, controllers, chipset components, programmable logic arrays (PLAs), memory chips, network chips, systems on chip (SoCs), SSD/NAND controller ASICs, and the like. In addition, in some of the drawings, signal conductor lines are represented with lines. Some may be different, to indicate more constituent signal paths, have a number label, to indicate a number of constituent signal paths, and/or have arrows at one or more ends, to indicate primary information flow direction. This, however, should not be construed in a limiting manner. Rather, such added detail may be used in connection with one or more exemplary embodiments to facilitate easier understanding of a circuit. Any represented signal lines, whether or not having additional information, may actually comprise one or more signals that may travel in multiple directions and may be implemented with any suitable type of signal scheme, e.g., digital or analog lines implemented with differential pairs, optical fiber lines, and/or single-ended lines.

Unless specifically stated otherwise, it may be appreciated that terms such as "processing," "computing," "calculating," "determining," or the like, refer to the action and/or processes of a computer or computing system, or similar electronic computing device, that manipulates and/or transforms data represented as physical quantities (e.g., electronic) within the computing system's registers and/or memories into other data similarly represented as physical quantities within the computing system's memories, registers or other such information storage, transmission or display devices. The embodiments are not limited in this context.

Example sizes/models/values/ranges may have been given, although embodiments are not limited to the same. As manufacturing techniques (e.g., photolithography) mature over time, it is expected that devices of smaller size could be manufactured. In addition, well known power/ground connections to IC chips and other components may or may not be shown within the figures, for simplicity of illustration and discussion, and so as not to obscure certain aspects of the embodiments. Further, arrangements may be shown in block diagram form in order to avoid obscuring embodiments, and also in view of the fact that specifics with respect to implementation of such block diagram arrangements are highly dependent upon the platform within which the embodiment is to be implemented, i.e., such specifics should be well within purview of one skilled in the art. Where specific details (e.g., circuits) are set forth in order to describe example embodiments, it should be apparent to one skilled in the art that embodiments can be practiced without, or with variation of, these specific details. The description is thus to be regarded as illustrative instead of limiting.

The term "coupled" may be used herein to refer to any type of relationship, direct or indirect, between the components in question, and may apply to electrical, mechanical, fluid, optical, electromagnetic, electromechanical, or other connections. In addition, the terms "first", "second", etc. may be used herein only to facilitate discussion, and carry no particular temporal or chronological significance unless otherwise indicated.

As used in this application and in the claims, a list of items joined by the term "one or more of" may mean any combination of the listed terms. For example, the phrases "one or more of A, B or C" may mean A; B; C; A and B; A and C; B and C; or A, B and C.

Those skilled in the art will appreciate from the foregoing description that the broad techniques of the embodiments can be implemented in a variety of forms. Therefore, while the embodiments have been described in connection with particular examples thereof, the true scope of the embodiments should not be so limited since other modifications will become apparent to the skilled practitioner upon a study of the drawings, specification, and following claims.

## Claims

1. A semiconductor apparatus comprising:
one or more substrates; and
a memory controller comprising a logic (125) coupled to the one or more substrates, wherein the logic is implemented at least partly in one or more of configurable or fixed-functionality hardware logic, the logic (125) being configured to:
map, via the memory controller (124), cached data in a dynamic random access memory (128) to an original address of copied data in a persistent memory (130), wherein the memory controller includes a two level memory controller mode that uses the dynamic random access memory as a transparent cache for the persistent memory;
track, via the memory controller, whether the cached data in the dynamic random access memory is valid or invalid data with respect to the copied data in the persistent memory;
evict, via the memory controller, the cached data from the dynamic random access memory;
bypass, via the memory controller, a writeback of the cached data when the cached data is tracked as invalid data;
**characterised in that** the logic is further configured to:
receive, via the memory controller, a free buffer command from an active application indicating that the cached data is invalid data, and wherein the operation to track the cached data as invalid data is based on the received free buffer command.

2. The semiconductor apparatus of any one of claims 1, wherein the operation to track the cached data as valid or invalid includes an operation to mark, via the memory controller, the cached data as valid or invalid and as dirty or clean, wherein the operation to bypass the writeback of the cached data is performed in response to the cached data is marked as dirty but invalid.

3. The semiconductor apparatus of claim 2, wherein one or more of the operations to: track valid or invalid data, mark the cached data as valid or invalid and as dirty or clean, evict the cached data, and bypass the writeback, are performed in the two level memory controller mode by the memory controller.

4. The semiconductor apparatus of any one of claims 2 to 3, wherein the operation to mark the cached data as dirty but invalid is based on one or more of the following events: upon a system shutdown, and a closing of an active application.

5. The semiconductor apparatus of any one of claims 2 to 4, the logic further configured to:
perform, via the memory controller, the writeback of the cached data that has been evicted to the persistent memory when the cached data is marked as dirty and valid data.

6. The semiconductor apparatus of any one of claims 2 to 5, wherein the dirty data includes one or more of the following: duplicate data, outdated data, insecure data, incorrect data, incomplete data, and inconsistent data.

7. A storage device comprising:
a tiered memory (120) including the dynamic random access memory (128) and the persistent memory (130); and
a semiconductor apparatus according to any one of the preceding claims coupled to the tiered memory.

8. A method (500), comprising:
mapping (502), via a memory controller of a memory device, cached data in a dynamic random access memory to an original address of copied data in a persistent memory, wherein the memory controller includes a two level memory controller mode that uses the dynamic random access memory as a transparent cache for the persistent memory;
tracking (506), via the memory controller, whether the cached data in the dynamic random access memory is valid or invalid data with respect to the copied data in the persistent memory;
evicting (508), via the memory controller, the cached data from the dynamic random access memory;
bypassing (510), via the memory controller, a writeback of the cached data when the cached data is tracked as invalid data;
**characterised by**:
receiving, via the memory controller, a free buffer command from an active application indicating that the cached data is invalid data, and wherein the operation to track the cached data as invalid data is based on the received free buffer command.

9. The method of any one of claims 8, wherein the operation to track the cached data as valid or invalid is based on an operation to mark, via the memory controller, the - cached data as valid or invalid and as dirty or clean, wherein the operation to bypass the writeback of the cached data is performed in response to the cached data is marked as dirty but invalid,
wherein one or more of the operations to: track valid or invalid data, mark the cached data as valid or invalid and as dirty or clean, evict the cached data, and bypass the writeback, are performed in the two level memory controller mode by the memory controller, and
wherein the operation to mark the cached data as dirty but invalid is based on one or more of the following events: upon a system shutdown, and a closing of the active application.

10. A machine-readable storage including machine-readable instructions, which when executed, implement the method of any one of claims 8 to 9.

## Patentansprüche

1. Eine Halbleitervorrichtung, umfassend:
ein oder mehrere Substrate; und
eine Speichersteuerung, umfassend eine Logik (125), die mit dem einen oder den mehreren Substraten gekoppelt ist, wobei die Logik zumindest teilweise in einer oder mehreren von konfigurierbarer Logik oder Hardware-Logik mit fester Funktionalität implementiert ist, wobei die Logik (125) ausgebildet ist zum:
Abbilden, über die Speichersteuerung (124), von in einem dynamischen Direktzugriffsspeicher (128) zwischengespeicherten Daten auf eine ursprüngliche Adresse von kopierten Daten in einem persistenten Speicher (130), wobei die Speichersteuerung einen zweistufigen Speichersteuerungsmodus umfasst, der den dynamischen Direktzugriffsspeicher als einen transparenten Cache für den persistenten Speicher verwendet;
Verfolgen, über die Speichersteuerung, ob die in dem dynamischen Direktzugriffsspeicher zwischengespeicherten Daten gültige oder ungültige Daten in Bezug auf die kopierten Daten in dem persistenten Speicher sind;
Entfernen, über die Speichersteuerung, der zwischengespeicherten Daten aus dem dynamischen Direktzugriffsspeicher;
Umgehen, über die Speichersteuerung, eines Rückschreibens der zwischengespeicherten Daten, wenn die zwischengespeicherten Daten als ungültige Daten verfolgt werden;
**dadurch gekennzeichnet, dass** die Logik ferner ausgebildet ist zum:
Empfangen, über die Speichersteuerung, eines Freier-Puffer-Befehls von einer aktiven Anwendung, der anzeigt, dass die zwischengespeicherten Daten ungültige Daten sind, und wobei die Operation zum Verfolgen der zwischengespeicherten Daten als ungültige Daten auf dem empfangenen Freier-Puffer-Befehl basiert.

2. Die Halbleitervorrichtung gemäß einem der Ansprüche 1, wobei die Operation zum Verfolgen der zwischengespeicherten Daten als gültig oder ungültig eine Operation zum Markieren, über die Speichersteuerung, der zwischengespeicherten Daten als gültig oder ungültig und als unsauber oder sauber umfasst, wobei die Operation zum Umgehen des Rückschreibens der zwischengespeicherten Daten ansprechend darauf durchgeführt wird, dass die zwischengespeicherten Daten als unsauber, aber ungültig markiert werden.

3. Die Halbleitervorrichtung gemäß Anspruch 2, wobei eine oder mehrere der Operationen zum: Verfolgen von gültigen oder ungültigen Daten, Markieren der zwischengespeicherten Daten als gültig oder ungültig und als unsauber oder sauber, Entfernen der zwischengespeicherten Daten und Umgehen des Rückschreibens in dem zweistufigen Speichersteuerungsmodus durch die Speichersteuerung durchgeführt werden.

4. Die Halbleitervorrichtung gemäß einem der Ansprüche 2 bis 3, wobei die Operation zum Markieren der zwischengespeicherten Daten als unsauber, aber ungültig auf einem oder mehreren der folgenden Ereignisse basiert: bei einer Systemabschaltung und einem Schließen einer aktiven Anwendung.

5. Die Halbleitervorrichtung gemäß einem der Ansprüche 2 bis 4, wobei die Logik ferner ausgebildet ist zum:
Durchführen, über die Speichersteuerung, des Rückschreibens der zwischengespeicherten Daten, die entfernt wurden, in den persistenten Speicher, wenn die zwischengespeicherten Daten als unsaubere und gültige Daten markiert werden.

6. Die Halbleitervorrichtung gemäß einem der Ansprüche 2 bis 5, wobei die unsauberen Daten eines oder mehrere der folgenden umfassen: Duplikatdaten, veraltete Daten, unsichere Daten, inkorrekte Daten, unvollständige Daten und inkonsistente Daten.

7. Eine Speicherungsvorrichtung, umfassend:
einen gestuften Speicher (120), umfassend den dynamischen Direktzugriffsspeicher (128) und den persistenten Speicher (130); und
eine Halbleitervorrichtung gemäß einem der vorangehenden Ansprüche, die mit dem gestuften Speicher gekoppelt ist.

8. Ein Verfahren (500), umfassend:
Abbilden (502), über eine Speichersteuerung einer Speichervorrichtung, von in einem dynamischen Direktzugriffsspeicher zwischengespeicherten Daten auf eine ursprüngliche Adresse von kopierten Daten in einem persistenten Speicher, wobei die Speichersteuerung einen zweistufigen Speichersteuerungsmodus umfasst, der den dynamischen Direktzugriffsspeicher als einen transparenten Cache für den persistenten Speicher verwendet;
Verfolgen (506), über die Speichersteuerung, ob die in dem dynamischen Direktzugriffsspeicher zwischengespeicherten Daten gültige oder ungültige Daten in Bezug auf die kopierten Daten in dem persistenten Speicher sind;
Entfernen (508), über die Speichersteuerung, der zwischengespeicherten Daten aus dem dynamischen Direktzugriffsspeicher;
Umgehen (510), über die Speichersteuerung, eines Rückschreibens der zwischengespeicherten Daten, wenn die zwischengespeicherten Daten als ungültige Daten verfolgt werden;
**gekennzeichnet durch**:
Empfangen, über die Speichersteuerung, eines Freier-Puffer-Befehls von einer aktiven Anwendung, der anzeigt, dass die zwischengespeicherten Daten ungültige Daten sind, und wobei die Operation zum Verfolgen der zwischengespeicherten Daten als ungültige Daten auf dem empfangenen Freier-Puffer-Befehl basiert.

9. Das Verfahren gemäß einem der Ansprüche 8, wobei die Operation zum Verfolgen der zwischengespeicherten Daten als gültig oder ungültig auf einer Operation zum Markieren, über die Speichersteuerung, der zwischengespeicherten Daten als gültig oder ungültig und als unsauber oder sauber basiert, wobei die Operation zum Umgehen des Rückschreibens der zwischengespeicherten Daten ansprechend darauf durchgeführt wird, dass die zwischengespeicherten Daten als unsauber, aber ungültig markiert werden,
wobei eine oder mehrere der Operationen zum: Verfolgen von gültigen oder ungültigen Daten, Markieren der zwischengespeicherten Daten als gültig oder ungültig und als unsauber oder sauber, Entfernen der zwischengespeicherten Daten und Umgehen des Rückschreibens in dem zweistufigen Speichersteuerungsmodus durch die Speichersteuerung durchgeführt werden, und
wobei die Operation zum Markieren der zwischengespeicherten Daten als unsauber, aber ungültig auf einem oder mehreren der folgenden Ereignisse basiert: bei einer Systemabschaltung und einem Schließen der aktiven Anwendung.

10. Eine maschinenlesbare Speicherung, die maschinenlesbare Anweisungen umfasst, die bei Ausführung das Verfahren gemäß einem der Ansprüche 8 bis 9 implementieren.

## Revendications

1. Appareil semi-conducteur comprenant :
un ou plusieurs substrats ; et
un contrôleur de mémoire comprenant une logique (125) couplée au ou aux substrats, dans lequel la logique est implémentée au moins partiellement dans une ou plusieurs d'une logique matérielle configurable ou à fonctionnalité fixe, la logique (125) étant configurée pour :
mapper, via le contrôleur de mémoire (124), des données mises en cache dans une mémoire vive dynamique (128) à une adresse d'origine de données copiées dans une mémoire persistante (130), dans lequel le contrôleur de mémoire comprend un mode de contrôleur de mémoire à deux niveaux qui utilise la mémoire vive dynamique comme cache transparent pour la mémoire persistante ;
suivre, via le contrôleur de mémoire, si les données mises en cache dans la mémoire vive dynamique sont des données valides ou non valides par rapport aux données copiées dans la mémoire persistante ;
expulser, via le contrôleur de mémoire, les données mises en cache de la mémoire vive dynamique ;
contourner, via le contrôleur de mémoire, une réécriture des données mises en cache lorsque les données mises en cache sont suivies comme des données non valides ;
**caractérisé en ce que** la logique est en outre configurée pour :
recevoir, via le contrôleur de mémoire, une commande de tampon libre d'une application active indiquant que les données mises en cache sont des données non valides, et dans lequel l'opération pour suivre les données mises en cache comme des données non valides est basée sur la commande de tampon libre reçue.

2. Appareil semi-conducteur selon l'une des revendications 1, dans lequel l'opération pour suivre les données mises en cache comme valides ou non valides comprend une opération pour marquer, via le contrôleur de mémoire, les données mises en cache comme valides ou non valides et comme sales ou propres, dans lequel l'opération pour contourner la réécriture des données mises en cache est effectuée en réponse au fait que les données mises en cache sont marquées comme sales mais non valides.

3. Appareil semi-conducteur selon la revendication 2, dans lequel une ou plusieurs des opérations pour : suivre des données valides ou non valides, marquer les données mises en cache comme valides ou non valides et comme sales ou propres, expulser les données mises en cache, et contourner la réécriture, sont effectuées dans le mode de contrôleur de mémoire à deux niveaux par le contrôleur de mémoire.

4. Appareil semi-conducteur selon l'une des revendications 2 à 3, dans lequel l'opération pour marquer les données mises en cache comme sales mais non valides est basée sur un ou plusieurs des événements suivants : lors d'un arrêt de système et d'une fermeture d'une application active.

5. Appareil semi-conducteur selon l'une des revendications 2 à 4, la logique étant en outre configurée pour :
effectuer, via le contrôleur de mémoire, la réécriture des données mises en cache qui ont été expulsées dans la mémoire persistante lorsque les données mises en cache sont marquées comme des données sales et valides.

6. Appareil semi-conducteur selon l'une des revendications 2 à 5, dans lequel les données sales comprennent une ou plusieurs des suivantes : des données dupliquées, des données obsolètes, des données non sécurisées, des données incorrectes, des données incomplètes et des données incohérentes.

7. Dispositif de stockage comprenant :
une mémoire étagée (120) comprenant la mémoire vive dynamique (128) et la mémoire persistante (130) ; et
un appareil semi-conducteur selon l'une des revendications précédentes couplé à la mémoire étagée.

8. Procédé (500) comprenant le fait de :
mapper (502), via un contrôleur de mémoire d'un dispositif de mémoire, des données mises en cache dans une mémoire vive dynamique à une adresse d'origine de données copiées dans une mémoire persistante, dans lequel le contrôleur de mémoire comprend un mode de contrôleur de mémoire à deux niveaux qui utilise la mémoire vive dynamique comme cache transparent pour la mémoire persistante ;
suivre (506), via le contrôleur de mémoire, si les données mises en cache dans la mémoire vive dynamique sont des données valides ou non valides par rapport aux données copiées dans la mémoire persistante ;
expulser (508), via le contrôleur de mémoire, les données mises en cache de la mémoire vive dynamique ;
contourner (510), via le contrôleur de mémoire, une réécriture des données mises en cache lorsque les données mises en cache sont suivies comme des données non valides ;
**caractérisé par** le fait de :
recevoir, via le contrôleur de mémoire, une commande de tampon libre d'une application active indiquant que les données mises en cache sont des données non valides, et dans lequel l'opération pour suivre les données mises en cache comme des données non valides est basée sur la commande de tampon libre reçue.

9. Procédé selon l'une des revendications 8, dans lequel l'opération pour suivre les données mises en cache comme valides ou non valides est basée sur une opération pour marquer, via le contrôleur de mémoire, les données mises en cache comme valides ou non valides et comme sales ou propres, dans lequel l'opération pour contourner la réécriture des données mises en cache est effectuée en réponse au fait que les données mises en cache sont marquées comme sales mais non valides,
dans lequel une ou plusieurs des opérations pour : suivre des données valides ou non valides, marquer les données mises en cache comme valides ou non valides et comme sales ou propres, expulser les données mises en cache, et contourner la réécriture, sont effectuées dans le mode de contrôleur de mémoire à deux niveaux par le contrôleur de mémoire, et
dans lequel l'opération pour marquer les données mises en cache comme sales mais non valides est basée sur un ou plusieurs des événements suivants : lors d'un arrêt de système et d'une fermeture de l'application active.

10. Stockage lisible par machine comprenant des instructions lisibles par machine qui, lorsqu'elles sont exécutées, implémentent le procédé selon l'une des revendications 8 à 9.
